# EUROPÄISCHE PATENTSCHRIFT

(11) **EP 2 902 526 B1**
(45) Veröffentlichungstag und Bekanntmachung des Hinweises auf die Patenterteilung: **06.03.2019**
(21) Anmeldenummer: 15152804.9
(22) Anmeldetag: 28.01.2015
(51) Int. Cl.: C23C 14/16, F16C 33/12, C22C 13/00

(54) **MEHRSCHICHTGLEITLAGER**
MULTI-LAYER SLIDING BEARING
PALIER LISSE MULTICOUCHE

(30) Priorität: 31.01.2014 AT 500702014
(43) Veröffentlichungstag der Anmeldung: 05.08.2015
(73) Patentinhaber: Miba Gleitlager Austria GmbH, 4663 Laakirchen (AT)
(72) Erfinder: Gärtner, Walter, 4810 Gmunden (AT); Nagl, Johann, 4651 Stadl-Paura (AT); Übleis, Christian, 4616 Weißkirchen a. d. Traun (AT); Zidar, Jakob, 4813 Altmünster (AT)
(74) Vertreter: Burger, Hannes

(56) Entgegenhaltungen:
- EP-A1- 2 333 129
- EP-A2- 2 341 257
- AT-A4- 505 664
- CN-A- 102 418 077
- GB-A- 2 169 616

## Beschreibung

Die Erfindung betrifft ein Mehrschichtgleitlager gemäß Anspruch 1 mit einer Stützschicht und einer Gleitschicht, sowie gegebenenfalls einer Lagermetallschicht, die auf der Stützschicht angeordnet ist, und gegebenenfalls zumindest einer Zwischenschicht, die zwischen der Gleitschicht und der Stützschicht, insbesondere auf der Lagermetallschicht, angeordnet ist oder sind, wobei die Gleitschicht aus einer Zinnbasis-Legierung mit einer Zinnmatrix besteht, die neben Zinn auch noch Antimon, Kupfer und gegebenenfalls zumindest ein Element aus einer ersten Gruppe bestehend aus Silizium, Chrom, Titan, Zink, Silber und Eisen enthält, wobei der Anteil an Antimon zwischen 1 Gew.-% und 8 Gew.-%, der Anteil an Kupfer zwischen 8 Gew.-% und 20 Gew.-%, der Anteil für jedes der Elemente Silizium, Chrom, Titan, Zink, Silber, Eisen zwischen 0,1 Gew.-% und 2 Gew.-%, beträgt, und wobei der Summengehalt aller Legierungselemente maximal 30 Gew.-% beträgt und den Rest Zinn mit den herstellungsbedingten Verunreinigungen bildet, wobei zumindest ein Anteil des Kupfer mit Zinn eine kupferreiche Hartphase bildet, die als Ausscheidung in der Zinnmatrix vorliegt.

Weiter betrifft die Erfindung ein Verfahren zur Herstellung eines Mehrschichtgleitlagers gemäß Anspruch 8 mit einer Stützschicht und einer Gleitschicht, wobei die Gleitschicht als Zinnbasis-Legierung mit einer Zinnmatrix hergestellt wird, die neben Zinn auch noch Antimon, Kupfer und gegebenenfalls zumindest ein Element aus einer ersten Gruppe bestehend aus Silizium, Chrom, Titan, Zink, Silber und Eisen enthält, wobei der Anteil an Antimon zwischen 1 Gew.-% und 8 Gew.-%, der Anteil an Kupfer zwischen 8 Gew.-% und 20 Gew.-% und der Anteil an dem zumindest einen Element zwischen 0,1 Gew.-% und 2 Gew.-% für jedes der Elemente Silizium, Chrom, Titan, Zink, Silber und Eisen, gewählt wird, und wobei der Summengehalt aller Legierungselemente maximal 30 Gew.-% gewählt wird und den Rest Zinn mit den herstellungsbedingten Verunreinigungen bildet, wobei aus zumindest einem Anteil des Kupfers mit Zinn eine kupferreiche Hartphase hergestellt wird.

Eine in der Zukunft absehbare Erhöhung der Zünddrücke bei Großmotoren erfordert eine Gleitlagerlösung, die eine geringere Ermüdungsneigung als bekannte Gleitlager aus bisher verwendeten Werkstoffen aufweist. Gleichzeitig soll die Dauerfestigkeit verbessert, die Fressneigung und die Korrosionsbeständigkeit gegenüber Heavy-Fuel Operation verringert werden. Eine entsprechende Anpassungsfähigkeit der Gleitschicht gegenüber Schmutzpartikeln und zum Ausgleich von Fertigungstoleranzen von Wellen ist ebenfalls erforderlich.

Die Verwendung von Zinnbasis-Legierungen für Gleitschichten von Gleitlagern ist im Stand der Technik bereits beschrieben worden.

Beispielsweise beschreibt die WO 2009/108975 A1 eine bis auf unvermeidbare Verunreinigungen cadmium-, blei-, arsen- und chromfreie gegossene Gleitlagerlegierung aus Weißmetall auf Zinnbasis, das 4 bis 30 Gew.-% Antimon als Hauptlegierungselement und 1 bis 10 Gew.-% Kupfer enthält, und das wenigstens ein Element aus einer Kobalt, Mangan, Scandium und Germanium enthaltenden Elementgruppe in einer auf die eingesetzten Elemente dieser Gruppe bezogenen Gesamtkonzentration zwischen 0,2 und 2,6 Gew.-% sowie mindestens ein Element aus einer Magnesium, Nickel, Zirkonium und Titan enthaltenden Elementgruppe in einer auf die eingesetzten Elemente dieser Gruppe bezogenen Gesamtkonzentration zwischen 0,05 und 1 ,7 Gew.-% aufweist, wobei der Summenanteil von Antimon und Kupfer bei einem zumindest dem dreifachen Kupfergehalt entsprechenden Antimongehalt höchstens 35 Gew.-% beträgt. Das Weißmetall kann einen Aluminiumanteil von 0,05 bis 2,5 Gew.-% aufweisen.

Die EP 2 333 129 A1 beschreibt ein Mehrschichtgleitlager umfassend zumindest eine Stützmetallschicht, eine Gleitschicht und gegebenenfalls eine zwischen der Gleitschicht und der Stützmetallschicht angeordnete Lagermetallschicht. Zwischen der Lagermetallschicht und der Gleitschicht kann eine Zwischenschicht angeordnet sein, die aus einer oder mehreren Teilschichten besteht, die galvanisch abgeschieden oder durch Diffusion gebildet werden, wobei jede der Teilschichten eines oder mehrere Elemente der Gruppe Chrom, Nickel, Eisen, Kobalt, Kupfer und Zinn enthält. Die galvanisch abgeschiedene Gleitschicht besteht aus einer Zinnbasislegierung, die neben Zinn als Hauptlegierungselement zumindest ein weiteres Element aus der Gruppe Antimon und Kupfer, gegebenenfalls Blei und/oder Bismut, sowie gegebenenfalls zumindest ein Element aus einer Gruppe umfassend Zirkonium, Silizium, Zink, Nickel und Silber, und aus der Herstellung der Elemente stammende unvermeidbare Verunreinigungen enthält, wobei der Antimonanteil maximal 20 Gew.-%, der Kupferanteil maximal 10 Gew.-%, der Summenanteil an Blei und Bismut maximal 1,5 Gew.-%, der Summenanteil an Kupfer und Antimon mindestens 2 Gew.-% und der Summenanteil an Zirkonium, Silizium, Zink, Nickel und Silber maximal 3 Gew.-% beträgt und wobei Zinn gebunden in Form intermetallischer Phasen und frei als Zinnphase mit Beta-Zinnkörnern vorliegt, die eine mittlere Größe aufweisen, die zumindest einen Wert in µm aufweist, die sich nach der Formel K = A / (S + 3*C + O) errechnet, wobei K die mittlere Korngröße in µm, A einen Faktor, S den Legierungsanteil an Antimon in Gew.-%, C den Summenlegierungsanteil an Kupfer, Silber, Nickel, und O den Summenlegierungsanteil an Blei, Bismut, Zink, anderer Legierungselemente und nichtmetallischer Partikeln in Gew.-% bedeuten, und der Faktor A den Wert 50, insbesondere 70, vorzugsweise 100 hat und wobei die mittlere Korngröße das arithmetische Mittel aus den Werten bezeichnet, die sich je Korn als geometrisches Mittel der größten und der kleinsten Abmessung dieses Kornes, wie sie in einem Querschliff erkennbar ist, errechnet, wobei zur Mittelwertbildung vom größten im Querschliff erkennbaren Korn hin zu kleineren Körnern vorgegangen wird, bis die Summe der Querschnittsflächen der zur Mittelwertbildung herangezogenen Körner 80% der gesamten Querschnittfläche aller Beta-Zinn-Körner erreicht, wobei die Zinnkörner mit Beta-Zinn Struktur in der Zinnbasislegierung jedenfalls eine mittlere Korngröße von zumindest 2,5 µm aufweisen. Die Lagermetallschicht kann u.a. eine Kupfer-Zinn-Legierung sein. Als Werkstoff für die Stützmetallschicht wird Stahl beschrieben.

Die Aufgabe vorliegender Erfindung ist es, ein Gleitlager für einen schnell und mittelschnell laufenden (Groß)motor, insbesondere einen Viertakt-Dieselmotor, für Heavy Fuel Operation zu schaffen.

Es sei an dieser Stelle erwähnt, dass unter einem Großmotor ein Motor verstanden wird, der ein Gleitlager aufweist, das einen Durchmesser von mindestens 200 mm aufweist. Übliche Größen liegen z.B. im Bereich zwischen 200 mm und 400 mm Durchmesser.

Unter den Begriffen "schnell laufend" bzw. "mittelschnell laufend" wird bei Viertakt-Dieselgroßmotoren ein Drehzahlbereich von typischerweise 750-1000 U/min bzw. 500-750 U/min verstanden.

Unter dem Begriff "Heavy Fuel Operation" wird ein Motor verstanden, der mit Schweröl als Kraftstoff betrieben wird.

Die Aufgabe der Erfindung wird mit dem eingangs genannten Mehrschichtgleitlager gelöst, bei dem die kupferreiche Hartphase in Form von Nanopartikeln mit einer maximalen Partikelgröße von 50 nm vorliegt.

Weiter wird die Aufgabe der Erfindung durch das eingangs genannte Verfahren gelöst, nach dem die Gleitschicht nach einem PVD-Verfahren hergestellt wird und die kupferreiche Hartphase in Form von Nanopartikeln mit einer maximalen Partikelgröße von 50 nm hergestellt wird und/oder die Zinnbasislegierung aus Zinn, Antimon und Kupfer sowie gegebenenfalls zumindest einem Element der ersten Gruppe mit zumindest einem weiteren Element aus einer zweiten Gruppe bestehend aus Aluminium, Bismut und Nickel hergestellt wird, wobei der Anteil des zumindest einen weiteren Elementes zwischen 0,1 Gew.-% und 5 Gew.-% für jedes der Elemente Aluminium, Bismut und Nickel gewählt wird und wobei die kupferreiche Hartphase der Gleitschicht (5) mit einer Partikelgröße von größer als 50 nm hergestellt wird.

Von Vorteil ist dabei, dass die harten Nanopartikel der kupferreichen Zinnphase in der Zinnmatrix diffusionshemmend wirken und ein Korngrößenwachstum verhindern. Weiter wird die Ausbreitung von Rissen erschwert. Dies erhöht die Härte und Stabilität der weichen Zinnbasis, wodurch eine hohe Dauerfestigkeit bei gleichzeitiger Wahrung der duktilen Materialeigenschaften erzielt wird.

Alternativ oder zusätzlich dazu kann durch die Zugabe von zumindest einem der weiteren Elemente Aluminium, Bismut und Nickel eine Kornfeinung erreicht werden, sollte das Abscheideverfahren für sich alleine nicht die gewünschte Korngröße erzeugen. Es wird damit erreicht, dass kein bzw. kein wesentlicher Härteverlust der Gleitschicht während des Betriebes des Gleitlagers eintritt. Dadurch kann die Belastbarkeit der Gleitschicht verbessert werden.

Von Vorteil ist es, wenn sowohl die kupferreichen Nano-Hartpartikel als auch Aluminium und/oder Bismut und/oder Nickel in der Gleitschicht eingelagert sind. Allerdings können die einleitend genannten Anforderungen an ein Gleitlager für die genannten (Groß)motoren auch dann besser erfüllt werden wenn entweder die kupferreichen Nano-Hartpartikel oder Aluminium und/oder Bismut und/oder Nickel in der Gleitschicht vorhanden sind.

Gemäß einer Ausführungsvariante ist vorgesehen, dass der Summengehalt aller Legierungselemente neben Zinn zwischen 10 Gew.-% und 25 Gew.-% beträgt. Es können damit die voranstehend genannten Eigenschaften der Gleitschicht weiter verbessert werden.

Vorzugsweise besteht die Lagermetallschicht aus einer Bronze, wobei die Bronze gemäß einer bevorzugten Ausführungsvariante aus CuPb4Sn4Zn4, CuPb5Sn5Zn5, CuPb7Sn7Zn4, CuPb9Sn5, CuPb10Sn10, CuPb15Sn7, CuPb22Sn2, CuPb20Sn4, CuPb22Sn8, CuPb24Sn2, CuPb24Sn, CuPb24Sn4, CuSn5Zn, CuAl10Ni, CuSn10 besteht. (Für die Zusammensetzung aller angeführten Legierungsvarianten gilt ein Toleranzbereich von bis zu 5 Prozentpunkten, also beispielsweise CuPb4±2,5%Sn4±2,5%Zn4±2,5%). Insbesondere mit einer Lagermetallschicht aus Bronze bzw. aus diesen Bronzen kann in Mehrstoffgleitlagern mit der Gleitschicht nach der Erfindung eine verbesserte Anpassungsfähigkeit der Gleitschicht gegenüber Schmutzpartikeln erreicht werden, wobei eine derartige Lagemetallschicht auch entsprechend gute Notlaufeigenschaften aufweist.

Die Gleitschicht weist bevorzugt eine Schichtdicke in einem Bereich von 10 µm bis 60 µm in einem Mehrstoffgleitlager mit Lagermetallschicht oder in einem Bereich von 150 µm bis 1000 µm in einem Mehrstoffgleitlager ohne Lagermetallschicht auf. Es wird damit erreicht, dass die Gleitschicht eine gute Einbettungsfähigkeit von bei der Anwendung potentiell auftretenden Schmutzpartikeln aufweist, ohne dabei für Dauerbrüche anfällig zu sein.

In Hinblick auf die adaptiven Eigenschaften der Gleitschicht ist es von Vorteil, wenn diese eine Härte nach Vickers zwischen 15 HV(0,001) und 70 HV(0,001) aufweist. Dadurch kann eine verbesserte Einbettfähigkeit der Gleitschicht für Schmutzpartikeln unter gleichzeitiger Vermeidung von Spontanversagen erreicht werden.

Bevorzugt wird/werden die Zwischenschicht und/oder die Gleitschicht aus der Gasphase auf der Lagermetallschicht abgeschieden ist. Es können damit durch Verlangsamung oder Verhinderung von Teilchendiffusion die Koagulation von Ausscheidungen verringert bzw. verhindert und so Strukturen abseits des thermodynamischen Gleichgewichtes erzeugt werden.

Zum besseren Verständnis der Erfindung wird diese anhand der nachfolgenden Figur näher erläutert.

Es zeigt in schematisch vereinfachter Darstellung:

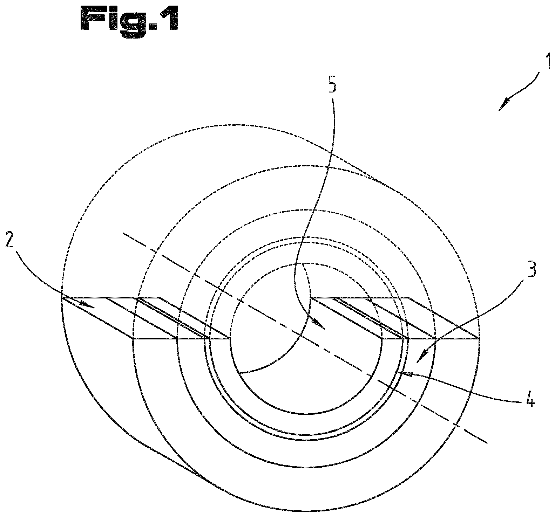

- Fig. 1: ein Mehrschichtgleitlager in Form einer Halbschale in Seitenansicht.

Einführend sei festgehalten, dass die in der Beschreibung gewählten Lageangaben, wie z.B. oben, unten, seitlich usw. auf die unmittelbar beschriebene sowie dargestellte Figur bezogen und bei einer Lageänderung sinngemäß auf die neue Lage zu übertragen sind.

Fig. 1 zeigt ein Mehrschichtgleitlager 1 in Form einer Gleitlagerhalbschale in Seitenansicht. Dargestellt ist die bevorzugte Ausführungsform dieses Mehrschichtgleitlagers 1, nämlich eine vierschichtige Variante bestehend aus einer Stützschicht 2, einer unmittelbar auf der Stützschicht 2 angeordneten Lagermetallschicht 3, einer unmittelbar auf der Lagermetallschicht 3 angeordneten Zwischenschicht 4 und einer unmittelbar auf der Zwischenschicht 4 angeordneten Gleitschicht 5.

Dieser prinzipielle Aufbau derartiger Vierschichtlager, wie sie z.B. in Kraftfahrzeugen Verwendung finden, ist aus dem Stand der Technik bekannt, sodass sich weitere Ausführungen hierzu erübrigen. Es sei jedoch erwähnt, dass weitere Schichten angeordnet werden können, also beispielsweise zwischen der Lagermetallschicht 3 und der Stützmetallschicht 2 eine Haftmittelschicht oder auf der Gleitschicht 5 eine Einlaufschicht. Ebenso kann auf der Rückseite der Stützschicht 2 eine Antifrettingschicht angeordnet sein.

Im Rahmen der Erfindung kann das Mehrschichtgleitlager 1 auch anders ausgeführt sein, beispielsweise als Lagerbuchse, wie dies in Fig. 1 strichliert angedeutet ist. Ebenso sind Ausführungen wie Anlaufringe, axial laufende Gleitschuhe, oder dergleichen möglich. Es sind auch Mehrschichtgleitlager 1 möglich die einen von 180 ° abweichenden Winkelbereich überdecken, sodass das Mehrschichtgleitlager 1 nicht zwingend als Halbschale ausgeführt sein muss, wenngleich dies die bevorzugte Ausführungsform ist.

Die Stützmetallschicht 2 besteht aus einem Werkstoff, welche dem Mehrschichtgleitlager 1 die erforderliche Strukturfestigkeit verleiht, beispielsweise aus einem Messing oder einer Bronze. In der bevorzugten Ausführungsvariante des Mehrschichtgleitlagers 1 besteht sie jedoch aus einem Stahl.

Als Lagermetallschicht 3 können unterschiedlichste Legierungen eingesetzt werden. Beispiele hierfür sind Lagermetalle auf Aluminiumbasis, z.B. AlSn6CuNi, AlSn20Cu, Al-Si4Cd, AlCd3CuNi, AlSi11Cu, AlSn6Cu, AlSn40, AlSn25CuMn, AlSi11CuMgNi, AlZn4Si. In der bevorzugten Ausführungsvariante des Mehrschichtgleitlagers 1 besteht die Lagermetallschicht 3 aufgrund der höheren Dauerfestigkeit jedoch aus einer Bronze. Insbesondere wird die Lagermetallschicht 3 aus einer Bronze hergestellt die neben Kupfer Blei in einem Mengenanteil von 2 Gew.-% bis 30 Gew.-% und/oder Zinn in einem Mengenanteil von 1 Gew.-% bis 15 Gew.-% und/oder Zink in einem Mengenanteil von 1 Gew.-% bis 8 Gew.-% und/oder Aluminium in einem Mengenanteil von 1 Gew.-% bis 4 Gew.-% und/oder Nickel in einem Mengenanteil von 1 Gew.-% bis 4 Gew.-% enthält. Beispielsweise kann die Lagermetallschicht 3 durch CuPb4Sn4Zn4, CuPb5Sn5Zn5, CuPb7Sn7Zn4, CuPb9Sn5, CuPb10Sn10, CuPb15Sn7, CuPb22Sn2, CuPb20Sn4, CuPb22Sn8, CuPb24Sn2, CuPb24Sn, CuPb24Sn4, CuSn5Zn, CuAl10Ni, CuSn10 gebildet sein. Für die Zusammensetzung aller angeführten Legierungsvarianten gilt ein Toleranzbereich von bis zu 5 Prozentpunkten, wie dies voranstehend bereits ausgeführt wurde.

Vorzugsweise wird die Lagermetallschicht 3 aus einer Bronze hergestellt die neben Kupfer 17 Gew.-% bis 27% Gew.-% Blei, 0,5 Gew.-% bis 8,5% Gew.-% Zinn oder in einer bleifreien Variante (<0,05Gew% Blei) 3,5 Gew.-% bis 7,0 Gew.-% Zinn und 0,5 Gew.-% bis 2,5 Gew.-% Zink enthält.

Die Lagermetallschicht 3 kann mit einem herkömmlichen, aus der Gleitlagertechnik bekannten Verfahren auf der Stützschicht 2 abgeschieden bzw. angeordnet werden. Beispielsweise kann ein Bimetall aus der Stützschicht 2 und der Lagermetallschicht 3 durch Aufwalzen der Lagermetallschicht 3 hergestellt werden. Ebenso kann die Lagermetallschicht 3 auf die Stützschicht 2 aufgegossen werden. Gegebenenfalls wird dieses Bimetall umgeformt und/oder spanabhebend bearbeitet.

Auf der Lagermetallschicht 3 (oder gegebenenfalls auf der Stützschicht 2) wird die Zwischenschicht 4 abgeschieden, insbesondere aus der Gasphase, bevorzugt nach einem Kathodensputterverfahren oder einem Elektronenstrahlbedampfungsverfahren. Da diese Verfahren prinzipiell aus dem Stand der Technik bekannt sind, sei zur Vermeidung von Wiederholungen darauf verwiesen.

Bevorzugt besteht die Zwischenschicht 4 aus Nickel oder einer Nickellegierung oder Eisen oder einer Eisenlegierung, beispielweise einem Edelstahl. Insbesondere wird die Zwischenschicht 4 mit einer Schichtdicke von mindestens 0,5 µm, vorzugsweise mindestens 0,8 µm, und maximal 3 µm, vorzugsweise maximal 2,1 µm, abgeschieden.

Es ist weiter bevorzugt, wenn die Zwischenschicht 4 eine Härte aufweist, die maximal dem Zehnfachen der Härte der Gleitschicht 5 entspricht. Es versteht sich von selbst, dass für die Härtemessungen zur Bestimmung dieser Relation dieselben Verfahren angewandt werden.

Es ist auch möglich mehrere Zwischenschichten 4 zwischen der Lagermetallschicht 3 und der Gleitschicht 5 vorzusehen. So kann es beispielsweise von Vorteil sein, wenn eine Zwischenschicht 4 aus Edelstahl und darauf eine weitere Zwischenschicht 4 aus Nickel angeordnet werden. Dabei können die Zwischenschicht 4 aus Edelstahl eine Schichtdicke zwischen 1 µm und 2 µm und die weitere Zwischenschicht 4 aus Nickel eine Schichtdicke zwischen 0,1 µm und 0,5 µm aufweisen.

Die Gleitschicht 5 besteht aus einer Zinnbasis-Legierung, die neben Zinn auch noch Antimon und Kupfer enthält. Gegebenenfalls kann die Gleitschicht 5 zumindest ein Element aus einer ersten Gruppe bestehend aus Silizium, Chrom, Titan, Zink, Silber und Eisen enthält. Weiter ist bevorzugt ein weiteres Element aus einer zweiten Gruppe bestehend aus Aluminium, Bismut und Nickel enthalten.

Der Anteil an Antimon beträgt zwischen 1 Gew.-% und 8 Gew.-%, insbesondere zwischen 1 Gew.-% und 5 Gew.-%. Bei einem Anteil unter 1 Gew.-% wird die Gleitschicht zu weich, wodurch die Dauerfestigkeit verschlechtert wird. Andererseits wird die Gleitschicht mit einem Anteil von mehr als 8 Gew.-% zu hart, sodass die Anpassungsfähigkeit der Gleitschicht 5 in der Einlaufphase zu gering ist.

Der Anteil an Kupfer beträgt zwischen 8 Gew.-% und 20 Gew.-%, insbesondere zwischen 9 Gew.-% und 15 Gew.-%. Bei einem Anteil von weniger als 8 Gew.-% ist der Anteil an sich bildenden Nanopartikeln zu gering, um das eingangs genannte Anforderungsprofil an die Gleitschicht 5 zu erfüllen. Übersteigt der Anteil an Kupfer jedoch 20 Gew.-% kommt es zu einer grobkörnigeren Ausscheidung der kupferreichen Hartphase, wodurch die gewünschten Eigenschaften ebenfalls nicht erreicht werden.

Der Anteil jedes der Elemente Silizium, Chrom, Titan Zink, Silber und Eisen kann zwischen 0,1 Gew.-% und 2 Gew.-%, insbesondere zwischen 0,25 Gew.-% und 1,5 Gew.-%, betragen.

Silizium kann zur Verbesserung der Dauerfestigkeit und zur Verlangsamung von Diffusionseffekten, wodurch es zu einer Schichtaufweichung kommen kann, zugegeben werden.

Durch die Zugabe von Chrom kann eine Verlangsamung der Korngrenzendiffusion erreicht werden.

Titan und Eisen wiederum bilden mit Zinn Hartphasen, wodurch die Dauerfestigkeit der Gleitschicht 5 verbessert werden kann.

Durch die Zugabe von Zink oder Silber erfolgt eine Kornfeinung des Gefüges, sodass kein Härteverlust im Betrieb auftritt, und andererseits damit die Dauerfestigkeit und die Belastbarkeit der Gleitschicht 5 verbessert wird.

Anteile dieser Elemente außerhalb der genannten Grenzen führen zu einem Eigenschaftsprofil der Gleitschicht 5, das den voranstehenden Anforderungen nicht gerecht wird.

Der Anteil jedes der weiteren Elemente Aluminium, Bismut und Nickel kann zwischen 0,1 Gew.-% und 5 Gew.-%, insbesondere zwischen 0,1 Gew.-% und 3,1 Gew.-%, betragen.

Aluminium verringert die Grobkörnigkeit des Gefüges und kann ebenfalls die Dauerfestigkeit der Gleitschicht 5 verbessern.

Durch die Zugabe von Nickel kann eine Kornfeinung des Gefüges erreicht werden, wodurch einerseits die Diffusion dergestalt gehemmt wird, dass kein Härteverlust im Betrieb auftritt, und andererseits damit die Dauerfestigkeit und die Belastbarkeit der Gleitschicht 5 verbessert wird.

Die Zugabe von Bismut verfeinert das Gefüge und behindert die Korngrenzendiffusion unter Temperatureinfluss.

Es wurde gefunden, dass Anteile an Aluminium, Bismut, Nickel außerhalb der angegebenen Mengenbereiche nicht zu dem gewünschten Ergebnis führen.

Der Summengehalt aller Legierungselemente neben Zinn ist auf maximal 30 Gew.-%, vorzugsweise auf einen Anteil zwischen 10 Gew.-% und 25 Gew.-%, beschränkt. Es wurde gefunden, dass Summengehalte oberhalb der angegebenen Mengenbereiche zu Sprödigkeit, unterhalb zu geringer Härte und Dauerfestigkeit der Gleitschicht 5 führen.

Den Rest auf 100 Gew.-% bildet Zinn mit den üblichen, herstellungsbedingten Verunreinigungen.

Neben dieser bevorzugten Vierschichtausführung des Mehrschichtgleitlagers 1 besteht im Rahmen der Erfindung auch die Möglichkeit, dass die Gleitschicht 5 direkt auf der Stützschicht 2 abgeschieden werden kann. Dabei kann die Stützschicht 2 gegebenenfalls auch ein Pleuel sein, in dessen Auge die Gleitschicht 5 abgeschieden wird.

Darüber hinaus besteht die Möglichkeit, dass das Mehrschichtgleitlager 1 den Aufbau Stützschicht 2 mit direkt darauf angeordneter Lagermetallschicht 3 und auf dieser direkt angeordneter Gleitschicht 5 hat.

Die Gleitschicht 5 wird aus der Gasphase vorzugsweise auf der Zwischenschicht 4 abgeschieden. Insbesondere wird die Gasphasenabscheidung nach einem Kathodensputterverfahren oder einem Elektronenstrahlbedampfungsverfahren durchgeführt, wobei bevorzugt Schichtdicken von mindestens 10 µm, vorzugsweise mindestens 15 µm, und maximal 60 µm, vorzugsweise maximal 50 µm, erzeugt werden, sofern eine Lagermetallschicht 3 angeordnet wird. Bei Fehlen einer Lagermetallschicht 3 werden bevorzugt Schichtdicken von mindestens 150 µm, vorzugsweise mindestens 200 µm, und maximal 1000 µm, vorzugsweise maximal 750 µm erzeugt.

Für die Abscheidung mittels Sputterverfahren können folgende Parameter angewandt werden:
Spannung am Substrat: -150 V bis 0 V
Atmosphäre: Argon
Druck: 7x10⁻⁴ bis 6x10⁻³ mbar,
Temperatur: 80 bis 160°C
Spannung an den Targets: -450 V bis -800 V

Die Abscheidung mittels eines PVD-Prozesses wird bevorzugt, da diese abseits des thermodynamischen Gleichgewichtes stattfinden, sodass die Teilchendiffusion und Koagulation von Ausscheidungen verhindert werden kann.

Während der Abscheidung der Gleitschicht 5 bildet sich die kupferreiche Hartphase aus, die aus η-Bronze (Cu₆Sn₅) besteht. Diese weisen aufgrund der Abscheidebedingungen eine maximale Korngröße von 50 nm auf. Vorzugsweise beträgt die Korngröße der Nanopartikel zwischen 10 nm und 40 nm.

Vorzugsweise weist die Zinnbasis-Legierungen nach dem Abscheiden eine Härte nach Vickers zwischen 15 HV(0,001) und 70 HV(0,001), insbesondere zwischen 35 HV(0,001) und 60 HV(0,001) auf.

Folgende Gleitschichten 5 wurden mittels eines PVD Verfahrens hergestellt. Dabei wurden Gleitlagerhalbschalen bestehend aus einer Stützschicht 2 aus Stahl und einer verbleiten Bronze als Lagermetallschicht 3 in einen elektromagnetisch erzeugten Metalldampf eingebracht, wobei eine Gleitschicht 5 mit einer Dicke von etwa 15 µm aufgebracht wurde. Die Erzeugung der Gleitschicht 5 kann sowohl von einer einzelnen Quelle, als auch gleichzeitig von mehreren Quellen gleicher oder unterschiedlicher Zusammensetzung erfolgen.

### Beispiel 1:

Als Gleitschicht 5 wurde eine Schicht der Zusammensetzung SnCu11Sb3, abgeschieden mittels Magnetronsputtern von einzelnem Sputtertarget erzeugt (Substrattemperatur 110°C, mittlere Beschichtungsrate 0,19 µm/min, Prozessgas Argon bei einem Druck von 0,7 Pa, Spannung am Substrat -50V, Spannung am Target 480V, Targetzusammensetzung SnCul 1Sb3). Diese Gleitschicht 5 wurde auf einer Zwischenschicht 4 aus Nickel mit einer Schichtdicke 1µm abgeschieden.

Die Gleitschicht 5 zeigt fein verteilte Nanoausscheidungen von Cu₆Sn₅ in der Zinnphase (minimale/mittlere/maximale Größe der Nanoausscheidungen 10/25/37 nm). Die Schicht weist eine Härte von 42 HV(0,001) auf.

### Beispiel 2:

Als Gleitschicht 5 wurde eine Schicht der Zusammensetzung SnCu12Sb4 mittels Magnetronsputtern von zwei Sputtertargets gleicher chemischer Zusammensetzung auf einer Zwischenschicht 4 aus Edelstahl (X5CrNi18-10) abgeschieden (Substrattemperatur 135°C, mittlere Beschichtungsrate 1,4 µm/min, Prozessgas Argon bei einem Druck von 3,8 Pa, Spannung am Substrat 0V, Spannung am Target jeweils 690V). Die Zwischenschicht 4 wies eine Schichtdicke von 1,5µm auf.

Die Gleitschicht 5 zeigt fein verteilte Nanoausscheidungen von Cu₆Sn₅ in der Zinnphase (minimale/mittlere/maximale Größe der Nanoausscheidungen 14/34/45 nm). Die Schicht weist eine Härte von 47 HV(0,001) auf.

### Beispiel 3:

Als Gleitschicht 5 wurde eine Schicht der Zusammensetzung SnCul3Sb2Nil mittels Magnetronsputtern von zwei Sputtertargets unterschiedlicher chemischer Zusammensetzung (Target 1: SnSb3, Target 2: CuNi8) auf einer Zwischenschicht 4 aus Nickel abgeschieden (Substrattemperatur 90°C, mittlere Beschichtungsrate 0,52µm/min, Prozessgas Argon bei einem Druck von 1,5 Pa, Spannung am Substrat 0V, Spannung am Target 1 825V, Spannung an Target 2 467 V). Die Zwischenschicht 4 wies eine Schichtdicke von 2 µm auf.

Die Gleitschicht 5 zeigt fein verteilte Nanoausscheidungen von Cu₆Sn₅ in der Zinnphase (minimale/mittlere/maximale Größe der Nanoausscheidungen 12/21/38 nm). Die Schicht weist eine Härte von 50 HV(0,001) auf.

Die Zwischenschichten 4 wurden mittels Magnetronsputtern von einzelnen Legierungstargets erzeugt (Substrattemperatur und Prozessgas-Druck siehe Ausführungsvarianten. Spannung am Target 640 V, mittlere Beschichtungsrate 0,5µm/min).

### Beispiel 4:

Als Gleitschicht 5 wurde eine Schicht der Zusammensetzung SnCulOSb4Nil mittels Elektronenstrahlbedampfung eines Stahlstreifens aus zwei Quellen hergestellt (direkte Beschichtung ohne Zwischenschicht und Lagermetallschicht 3). (Quelle 1: Grafittiegel mit reinem Antimon, Temperatur 720°C, Elektronenstrahlleistung 5,5kW; Quelle 2 wassergekühlter Kupfer-Tiegel mit SnCu25Ni10, Temperatur 1400°C, Elektronenstrahlleistung 80kW). Bei einer Vorschubgeschwindigkeit des Stahlstreifens von 0,2mm/s wurde eine Schichtdicke von 800µm aufgebracht, nach Umformen und Feinbohren des Gleitlagers betrug die Schichtdicke 650µm.

Die Gleitschicht 5 zeigt fein verteilte Nanoausscheidungen von Cu₆Sn₅ in der Zinnphase (minimale/mittlere/maximale Größe der Nanoausscheidungen 11/29/43 nm). Die Schicht weist eine Härte von 57 HV(0,001) auf.

Auf einer Prüfmaschine wurden die Schmutzverträglichkeit und die Dauerfestigkeit der Gleitlagerhalbschalen mit der jeweiligen Gleitschicht 5 entsprechend der Beispiele 1 bis 4 im Vergleich mit Werkstoffen aus dem Stand der Technik geprüft. Als Stand der Technik Werkstoffe wurden folgende Zusammensetzungen hergestellt:
Vergleichsbeispiel A: galvanisch aufgebrachte, 15 µm dicke PbSn18Cu2 Gleitschicht auf Bleibronze CuPb22Sn3 (Abscheidung aus Fluoroboratelektrolyt, siehe Dettner Heinz W., Elze Johannes; Handbuch der Galvanotechnik Band II; München: Carl Hansa Verlag 1966; Seite 863 ff). Diese Gleitschicht weist erfahrungsgemäß eine ausgezeichnete Schmutzverträglichkeit bei guter Dauerfestigkeit auf.

Die Schicht weist eine Härte von 14 HV(0,001) auf.

Vergleichsbeispiel B: gesputtert AlSn20Cul-Gleitschicht auf Bleibronze CuPb22Sn3 .

Abscheidebedingungen: Substrattemperatur 140°C, mittlere Beschichtungsrate 0,7 µm/min, Prozessgas Argon bei einem Druck von 1,5 Pa, Spannung am Substrat 0V, Spannung am Target 630V. Zwischenschichten mittels Magnetronsputtern von Nickel-Target (Substrattemperatur und Prozessgas-Druck wie Gleitschicht, Spannung am Target 640 V, mittlere Beschichtungsrate 0,5µm/min).

Die Schicht weist eine Härte von 84 HV(0,001) auf.

Weder bei Vergleichsbeispiel A noch Vergleichsbeispiel B konnten in der Hartphase Nanoausscheidungen mit einer maximalen Korngröße von 50 nm gefunden werden.

Weiter führt die gießtechnische Herstellung der beschriebenen Legierungen zu keiner Ausbildung von Nanoausscheidungen.

Diese Gleitschicht weist erfahrungsgemäß eine mittlere Schmutzverträglichkeit bei ausgezeichneter Dauerfestigkeit auf.

Messmethode zur Bestimmung der Korngröße der Nanoausscheidungen: Für jede Probe wurden REM-FIB Bilder (Vergrößerung 50k, Bildausschnitt 2,4x2,4µm) einer statistischen Bildauswertung zur Bestimmung der Korngröße der Nanoausscheidungen in der Hartphase unterzogen.

Bei der Schmutzverträglichkeitsprüfung wird bei oszillierender Belastung mit einer spezifischen Lastamplitude von 75 MPa das Öl sukzessive mit Hartpartikeln kontaminiert und die Schmutzmenge beim Zeitpunkt des Spontanversagens der Lagerschale gemessen. Dadurch kann eine Aussage über Gutmütigkeit und Schmutzverträglichkeit der Gleitschicht 5 getroffen werden.

Die Prüfung der Dauerfestigkeit erfolgte mit schwellender Last und einer spezifischen Lastamplitude von 75 MPa über 3 Millionen Lastzyklen bei einer Gleitgeschwindigkeit von 12 m/s. Nach der Prüfung wurden die Halbschalen vermessen und der Verschleiß der Gleitschicht 4 bestimmt. Die Dauerfestigkeit der Gleitschicht 5 wurde optisch beurteilt. Die optische Bewertung von 1 bis 5 deckt den Zustand von sehr gut (1: Laufspuren) bis sehr schlecht (5: großflächige, starke Dauerbrüche) ab.

Die Ergebnisse sind in Tabelle 1 zusammengefasst.

**Tabelle 1:**

| | Schmutzverträglichkeit | Dauerfestigkeit | |
|---|---|---|---|
| Beispiel | Schmutzmenge [mg] | optische Beurteilung | Verschleiß [µm] |
| 1 | 258 | 2 | 1,3 |
| 2 | 250 | 2 | 2,1 |
| 3 | 219 | 1,5 | 1,6 |
| 4 | 224 | 1,5 | 1,9 |
| A | 300 | 4 | 8,0 |
| B | 89 | 1 | 2,0 |

Tabelle 1 zeigt die Resultate, jeweils gemittelt über vier Versuche. Es zeigt sich, dass mit den Gleitschichten 5 gemäß den Beispielen 1 bis 4 eine sehr gute Schmutzverträglichkeit erreicht wurde. Gleichzeitig zeigen die Gleitschichten 5 gemäß den Beispielen 1 bis 4 nach Dauerbelastungstests nur vereinzelte Risse und keinen Verschleiß der über den Einlaufbedarf hinausgeht. Diese Kombination weist keines der Materialien aus dem Stand der Technik auf.

Neben den voranstehend genannten Beispielen wurden die in Tabelle 2 angeführten weiteren Zusammensetzungen der Gleitschicht 5 hergestellt. Sämtliche Angaben zu Zusammensetzungen in der folgenden Tabelle 2 sind als Gew.-% zu verstehen. Den Rest auf 100 Gew.-% bildet jeweils Zinn. Die Abkürzungen ZS und ES stehen dabei für eine Zwischenschicht allgemein bzw. für eine Zwischenschicht 4 aus einem Edelstahl X5CrNi18-10.

Diese Beispiele sind stellvertretend für Zusammensetzungen der Gleitschicht 5 entsprechend den voranstehend genannten Mengenbereichen der Legierungselemente zu verstehen.

Die Gleitschichten 5 der Beispiele 14 bis 22 wurden nach einem der voranstehend genannten PVD-Verfahren abgeschieden.

**Tabelle 2**

| Bsp. | Sb | Cu | Si | Cr | Bi | Ti | Fe | Al | Ni | Zn | Ag | ZS |
|---|---|---|---|---|---|---|---|---|---|---|---|---|
| 5a | 3,2 | 8,9 | | | | | | | | | | Ni |
| 5b | 3,2 | 8,9 | | | | | | | | | | Ni |
| 6 | 1,3 | 12,8 | | 0,5 | | | 0,2 | | | | | ES |
| 7 | 2,0 | 11,7 | | | | 1,7 | | | | | | Ni |
| 8 | 3,9 | 10,4 | | | 0,2 | | | | | 2,0 | | Ni |
| 9 | 2,2 | 11,0 | | | | | | | | | 1,8 | ES |
| 10 | 2,3 | 10,7 | | | | | | | | | | ES |
| 11 | 4,0 | 10,0 | 0,1 | | | | | 2,0 | | | | ES |
| 12 | 2,8 | 12,4 | | | | | | | 1,5 | | | Ni |
| 13 | 7,1 | 19,2 | | | | | | | | | | Ni |
| 14 | 3,2 | 8,9 | | 1,2 | | | | | | | | Ni |
| 15 | 1,3 | 12,8 | | 4,6 | | | | | | | | Ni |
| 16 | 2,0 | 11,7 | | 3,5 | | | | | | | | Ni |
| 17 | 3,2 | 8,9 | | | | | | 1,3 | | | | Ni |
| 18 | 1,3 | 12,8 | | | | | | 2,6 | | | | Ni |
| 19 | 2,0 | 11,7 | | | | | | 2,1 | | | | Ni |
| 20 | 3,2 | 8,9 | | | | | | | 0,9 | | | Ni |
| 21 | 1,3 | 12,8 | | | | | | | 1,6 | | | Ni |
| 22 | 2,0 | 11,7 | | | | | | | 1,9 | | | Ni |

Sämtliche Legierungen wurden auf einen Verbundwerkstoff aus einer Stützschicht 2 aus Stahl und einer Lagermetallschicht 3 aus CuPb22Sn3 (Bsp. 5 wurde zusätzlich auch auf einer Lagermetallschicht 3 aus CuZn5Sn abgeschieden - Variante b) sowie der in Tabelle 2 jeweils angegebenen Zwischenschicht 4 abgeschieden. Die Abscheidung erfolgte mittels Sputtern entsprechend den voranstehend genannten Parametern.

In Tabelle 3 sind die Testergebnisse zu diesen Beispielen zusammengefasst. Die Härten sind in HV(0,001) angegeben. Die Werte für die Korngröße der Nanopartikel sind als minimale/mittlere/maximale Korngröße angegeben.

Zu den Beispielen 14 bis 22 wurde die Korngröße nicht bestimmt. Diese Beispiele stehen stellvertretend für Ausführungsvarianten der Gleitschicht 5 ohne die Nanopartikel mit einer maximalen Korngröße von 50 nm in der kupferreichen Hartphase.

**Tabelle 3**

| | | | Schmutzverträglichkeit | Dauerfestigkeit | |
|---|---|---|---|---|---|
| Bsp. | Korngröße der Nanopartikel [nm] | Härte | Schmutzmenge [mg] | Verschleiß [µm] | Optische Bewertung |
| 5a | 12/25/40 | 50 | 222 | 2,7 | 1,5 |
| 5b | 10/22/40 | 48 | 206 | 3,2 | 2,0 |
| 6 | 10/23/43 | 48 | 168 | 4,3 | 3,5 |
| 7 | 12/21/34 | 63 | 137 | 3,1 | 2 |
| 8 | 10/27/46 | 52 | 194 | 5,0 | 3 |
| 9 | 12/21/39 | 54 | 141 | 6,1 | 3,5 |
| 10 | 10/27/44 | 49 | 225 | 3,2 | 2 |
| 11 | 10/28/42 | 55 | 145 | 3,4 | 2,5 |
| 12 | 12/31/45 | 56 | 153 | 2,5 | 2 |
| 13 | 13/34/48 | 65 | 144 | 1,9 | 1,9 |
| 14 | - | 51 | 199 | 3,1 | 2 |
| 15 | - | 55 | 229 | 2,8 | 2 |
| 16 | - | 52 | 205 | 2,9 | 2 |
| 17 | - | 48 | 189 | 4,1 | 3 |
| 18 | - | 58 | 140 | 3,6 | 2,5 |
| 19 | - | 55 | 145 | 3,8 | 2,5 |
| 20 | - | 54 | 144 | 4,5 | 3 |
| 21 | - | 57 | 138 | 4,1 | 3 |
| 22 | - | 58 | 139 | 4,3 | 3 |

Die Ausführungsbeispiele zeigen mögliche Ausführungsvarianten der Gleitschicht 5 bzw. des Mehrschichtgleitlagers 1.

Der Ordnung halber sei abschließend darauf hingewiesen, dass zum besseren Verständnis des Aufbaus des Mehrschichtgleitlagers 1 dieses bzw. dessen Bestandteile teilweise unmaßstäblich und/oder vergrößert und/oder verkleinert dargestellt wurden.

### Bezugszeichenliste

- 1: Mehrschichtgleitlager
- 2: Stützschicht
- 3: Lagermetallschicht
- 4: Zwischenschicht
- 5: Gleitschicht

## Patentansprüche

1. Mehrschichtgleitlager (1) mit einer Stützschicht (2) und einer Gleitschicht (5), sowie gegebenenfalls einer Lagermetallschicht (3), die auf der Stützschicht (2) angeordnet ist, und gegebenenfalls zumindest einer Zwischenschicht (4), die zwischen der Gleitschicht (5) und der Stützschicht (2), insbesondere auf der Lagermetallschicht (3), angeordnet ist oder sind, wobei die Gleitschicht (5) aus einer Zinnbasis-Legierung mit einer Zinnmatrix besteht, die neben Zinn auch noch Antimon, Kupfer und gegebenenfalls zumindest ein Element aus einer ersten Gruppe bestehend aus Silizium, Chrom, Titan, Zink, Silber und Eisen enthält, wobei der Anteil an Antimon zwischen 1 Gew.-% und 8 Gew.-%, der Anteil an Kupfer zwischen 8 Gew.-% und 20 Gew.-% und der Anteil an dem zumindest einen Element zwischen 0,1 Gew.-% und 2 Gew.-% für jedes der Elemente Silizium, Chrom, Titan, Zink, Silber und Eisen, beträgt, und wobei der Summengehalt aller Legierungselemente maximal 30 Gew.-% beträgt und den Rest Zinn mit den herstellungsbedingten Verunreinigungen bildet, wobei zumindest ein Anteil des Kupfer mit Zinn eine kupferreiche Hartphase bildet, die als Ausscheidung in der Zinnmatrix vorliegt, **dadurch gekennzeichnet, dass** die kupferreiche Hartphase in Form von Nanopartikeln mit einer maximalen Partikelgröße von 50 nm vorliegt.

2. Mehrschichtgleitlager nach Anspruch 1, **dadurch gekennzeichnet, dass** der Summengehalt aller Legierungselemente neben Zinn zwischen 10 Gew.-% und 25 Gew.-% beträgt.

3. Mehrschichtgleitlager (1) nach einem der Ansprüche 1 oder 2, **dadurch gekennzeichnet, dass** die Lagermetallschicht (3) aus einer Bronze besteht.

4. Mehrschichtgleitlager (1) nach Anspruch 3, **dadurch gekennzeichnet, dass** die Bronze aus CuPb4Sn4Zn4, CuPb5Sn5Zn5, CuPb7Sn7Zn4, CuPb9Sn5, CuPb10Sn10, CuPb15Sn7, CuPb22Sn2, CuPb20Sn4, CuPb22Sn8, CuPb24Sn2, CuPb24Sn, CuPb24Sn4, CuSn5Zn, CuAl10Ni, CuSn10 besteht.

5. Mehrschichtgleitlager (1) nach einem der Ansprüche 1 bis 4, **dadurch gekennzeichnet, dass** die Gleitschicht (5) eine Schichtdicke von mindestens 10 µm und maximal 60 µm in einem Mehrstoffgleitlager (1) mit einer Lagermetallschicht (3) oder von mindestens 150 µm und maximal 1000 µm in einem Mehrstoffgleitlager (1) ohne Lagermetallschicht (3) aufweist.

6. Mehrschichtgleitlager (1) nach einem der Ansprüche 1 bis 5, **dadurch gekennzeichnet, dass** die Gleitschicht (5) eine Härte nach Vickers zwischen 15 HV(0,001) und 70 HV(0,001) aufweist.

7. Mehrschichtgleitlager (1) nach einem der Ansprüche 1 bis 6, **dadurch gekennzeichnet, dass** zusätzlich zumindest ein weiteres Element aus einer zweiten Gruppe bestehend aus Aluminium, Bismut und Nickel in der Gleitschicht (5) enthalten ist, wobei der Anteil des zumindest einen weiteren Elementes zwischen 0,1 Gew.-% und 5 Gew.-% für jedes der Elemente Aluminium, Bismut und Nickel beträgt.

8. Verfahren zur Herstellung eines Mehrschichtgleitlagers (1) mit einer Stützschicht (2) und einer Gleitschicht (5), wobei die Gleitschicht (5) als Zinnbasis-Legierung mit einer Zinnmatrix hergestellt wird, die neben Zinn auch noch Antimon, Kupfer und gegebenenfalls zumindest ein Element aus einer ersten Gruppe bestehend aus Silizium, Chrom, Titan, Zink, Silber und Eisen enthält, wobei der Anteil an Antimon zwischen 1 Gew.-% und 8 Gew.-%, der Anteil an Kupfer zwischen 8 Gew.-% und 20 Gew.-% und der Anteil an dem zumindest einen Element zwischen 0,1 Gew.-% und 2 Gew.-% für jedes der Elemente Silizium, Chrom, Titan, Zink, Silber und Eisen, gewählt wird, und wobei der Summengehalt aller Legierungselemente maximal 30 Gew.-% gewählt wird und den Rest Zinn mit den herstellungsbedingten Verunreinigungen bildet, wobei aus zumindest einem Anteil des Kupfers mit Zinn eine kupferreiche Hartphase hergestellt wird, die als Ausscheidung in der Zinnmatrix vorliegt, **dadurch gekennzeichnet, dass** die Gleitschicht (5) nach einem PVD-Verfahren hergestellt wird und
- dass die kupferreiche Hartphase in Form von Nanopartikeln mit einer maximalen Partikelgröße von 50 nm hergestellt wird und/oder
- dass die Zinnbasislegierung aus Zinn, Antimon und Kupfer sowie gegebenenfalls zumindest ein Element der ersten Gruppe mit zumindest einem weiteren Element aus einer zweiten Gruppe bestehend aus Aluminium, Bismut und Nickel hergestellt wird, wobei der Anteil des zumindest einen weiteren Elementes zwischen 0,1 Gew.-% und 5 Gew.-% für jedes der Elemente Aluminium, Bismut und Nickel gewählt wird und wobei die kupferreiche Hartphase der Gleitschicht (5) mit einer Partikelgröße von größer als 50 nm hergestellt wird.

## Claims

1. A multi-layered plain bearing (1) with a support layer (2) and a sliding layer (5), and if necessary a bearing metal layer (3) which is arranged on the support layer (2), and if necessary at least one intermediate layer (4) which is or are arranged between the sliding layer (5) and the support layer (2), in particular on the bearing metal layer (3), wherein the sliding layer (5) consists of a tin-based alloy with a tin matrix which, in addition to tin, also contains antimony, copper and if necessary at least one element from a first group comprising silicon, chromium, titanium, zinc, silver and iron, wherein the proportion of antimony is between 1 wt.% and 8 wt.%, the proportion of copper is between 8 wt.% and 20 wt.% and the proportion of the at least one element is between 0.1 wt.% and 2 wt.% for each of the elements silicon, chromium, titanium, zinc, silver and iron, and wherein the total content of all alloy elements is a maximum of 30 wt.% and the remainder is formed by tin and manufacturing-related impurities, wherein at least a proportion of the copper forms a copper-rich hard phase with tin, which is in the form of a deposit in the tin matrix, **characterized in that** the copper-rich hard phase is in the form of nanoparticles with a maximum particle size of 50 nm.

2. The multi-layered plain bearing according to claim 1, **characterized in that** the total content of all the alloy elements in addition to tin is between 10 wt.% and 25 wt.%.

3. The multi-layered plain bearing (1) according to one of claims 1 or 2, **characterized in that** the bearing metal layer (3) consists of a bronze.

4. The multi-layered plain bearing (1) according to claim 3, **characterized in that** the bronze consists of CuPb4Sn4Zn4, CuPb5Sn5Zn5, CuPb7Sn7Zn4, CuPb9Sn5, CuPb10Sn10, CuPb15Sn7, CuPb22Sn2, CuPb20Sn4, CuPb22Sn8, CuPb24Sn2, CuPb24Sn, CuPb24Sn4, CuSn5Zn, CuAl10Ni, CuSn10.

5. The multi-layered plain bearing (1) according to one of claims 1 to 4, **characterized in that** the sliding layer (5) has a layer thickness of at least 10 µm and of maximum 60 µm in a multi-component plain bearing (1) with a bearing metal layer (3) or of at least 150 µm and of maximum 1000 µm in a multi-component plain bearing (1) without a bearing metal layer (3).

6. The multi-layered plain bearing (1) according to one of claims 1 to 5, **characterized in that** the sliding layer (5) has a Vickers hardness of between 15 HV(0.001) and 70 HV(0.001).

7. The multi-layered plain bearing (1) according to one of claims 1 to 6, **characterized in that** in addition at least one further element from a second group comprising aluminium, bismuth and nickel is contained in the sliding layer (5), wherein the proportion of the at least one further element is between 0.1 wt.% and 5 wt.% for each of the elements aluminium, bismuth and nickel.

8. A method for producing a multi-layered plain bearing (1) with a support layer (2) and a sliding layer (5), wherein the sliding layer (5) is produced as a tin-based alloy with a tin matrix which, in addition to tin, also contains antimony, copper and if necessary at least one element from a first group comprising silicon, chromium, titanium, zinc, silver and iron, wherein the proportion of antimony is between 1 wt.% and 8 wt.%, the proportion of copper is between 8 wt.% and 20 wt.% and the proportion of the at least one element is between 0.1 wt.% and 2 wt.% for each of the elements silicon, chromium, titanium, zinc, silver and iron, and wherein the total content of all alloy elements is a maximum of 30 wt.% and the remainder is formed by tin and manufacturing-related impurities, wherein a copper-rich hard phase is produced from at least a proportion of the copper with tin, which hard phase is in the form of a deposit in the tin matrix, **characterized in that** the sliding layer (5) is produced using a PVD-process and
- that the copper-rich hard phase is produced in the form of nanoparticles with a maximum particle size of 50 nm and/or
- that the tin-based alloy is produced from tin, antimony and copper and also if necessary at least one element from a first group with at least one further element from a second group comprising aluminium, bismuth and nickel, wherein the proportion of the at least one further element is chosen at between 0.1 wt.% and 5 wt.% for each of the elements aluminium, bismuth and nickel and wherein the copper-rich hard phase of the sliding layer (5) is produced with a particle size greater than 50 nm.

## Revendications

1. Palier lisse multicouche (1) avec une couche de support (2) et une couche de glissement (5), ainsi que, le cas échéant, une couche métallique de palier (3) qui est disposée sur la couche de support (2) et, le cas échéant, au moins une couche intermédiaire (4), qui est disposée entre la couche de glissement (5) et la couche de support (2), plus particulièrement sur la couche métallique de palier (3), la couche de glissement (5) étant constituée d'un alliage à base d'étain avec une matrice d'étain qui, en plus de l'étain, contient également de l'antimoine, du cuivre et, le cas échéant, au moins un élément sélectionné dans un premier groupe constitué du silicium, du chrome, du titane, du zinc, de l'argent et du fer, la part d'antimoine étant entre 1 % en poids et 8 % en poids, la part de cuivre étant entre 8 % en poids et 20 % en poids et la part de l'au moins un élément étant entre 0,1 % en poids et 2 % en poids pour chacun des éléments silicium, chrome, titane, zinc, argent et fer et la teneur totale de tous des éléments de l'alliage étant de 30 % en poids maximum et l'étain constituant le reste avec les impuretés dues à la fabrication, au moins une part du cuivre formant, avec l'étain, une phase dure riche en cuivre, qui existe en tant que précipitation dans la matrice d'étain, **caractérisé en ce que** la phase dure riche en cuivre se présente sous la forme de nanoparticules avec une taille de particules maximum de 50 nm.

2. Palier lisse multicouche selon la revendication 1, **caractérisé en ce que** la teneur totale de tous les éléments de l'alliage en plus de l'étain est entre 10 % en poids et 25 % en poids.

3. Palier lisse multicouche (1) selon la revendication 1 ou 2, **caractérisé en ce que** la couche métallique de palier (3) est constituée d'un bronze.

4. Palier lisse multicouche (1) selon la revendication 3, **caractérisé en ce que** le bronze est constitué de CuPb4Sn4Zn4, CuPb5Sn5Zn5, CuPb7Sn7Zn4, CuPb9Sn5, CuPb10Sn10, CuPbl5Sn7, CuPb22Sn2, CuPb20Sn4, CuPb22Sn8, CuPb24Sn2, CuPb24Sn, CuPb24Sn4, CuSn5Zn, CuAl10Ni, CuSn10.

5. Palier lisse multicouche (1) selon l'une des revendications 1 à 4, **caractérisé en ce que** la couche de glissement (5) présente une épaisseur de couche d'au moins 10 µm et de 60 µm maximum dans un palier de glissement multi-matériau (1) avec une couche métallique de palier (3) ou d'au moins 150 µm et de 1000 µm maximum dans un palier de glissement multi-matériau (1) sans couche métallique de palier (3).

6. Palier lisse multicouche (1) selon l'une des revendications 1 à 5, **caractérisé en ce que** la couche de glissement (5) présente une dureté Vickers entre 15 HV(0,001) et 70 HV(0,001).

7. Palier lisse multicouche (1) selon l'une des revendications 1 à 6, **caractérisé en ce qu'**en outre au moins un élément supplémentaire sélectionné dans un groupe constitué de l'aluminium, du bismuth et du nickel, est contenu dans la couche de glissement (5), la part de l'au moins un élément supplémentaire étant entre 0,1 % en poids et 5 % en poids pour chacun des éléments aluminium, bismuth et nickel.

8. Procédé de fabrication d'un palier multicouche (1) avec une couche de support (2) et une couche de glissement (5), la couche de glissement (5) étant réalisé sous la forme d'un alliage à base d'étain avec une matrice d'étain qui contient, en plus de l'étain, également de l'antimoine, du cuivre et, le cas échéant, au moins un élément sélectionné dans un premier groupe constitué du silicium, du chrome, du titane, du zinc, de l'argent et du fer, la part d'antimoine étant entre 1 % en poids et 8 % en poids, la part de cuivre étant entre 8 % en poids et 20 % en poids et la part de l'au moins un élément étant entre 0,1 % en poids et 2 % en poids pour chacun des éléments silicium, chrome, titane, zinc, argent et fer et la teneur totale de tous des éléments de l'alliage étant de 30 % en poids maximum et l'étain constituant le reste avec les impuretés dues à la fabrication, à partir d'au moins une part du cuivre, une phase dure riche en cuivre étant réalisée avec l'étain, qui existe sous la forme d'une précipitation dans la matrice d'étain, **caractérisé en ce que** la couche de glissement (5) est fabriquée selon un procédé PVD et
- la phase dure riche en cuivre est réalisée sous la forme de nanoparticules avec une taille de particules maximum de 50 nm et/ou
- l'alliage à base d'étain est réalisé à partir d'étain, d'antimoine et de cuivre ainsi que, le cas échéant, d'au moins un élément du premier groupe avec au moins un élément supplémentaire sélectionné dans un deuxième groupe constitué de l'aluminium, du bismuth et du nickel, la part de l'au moins un élément supplémentaire étant entre 0,1 % en poids et 5 % en poids pour chacun des éléments aluminium, bismuth et nickel et la phase dure riche en cuivre de la couche de glissement (5) étant réalisée avec une taille de particules supérieure à 50 nm.
